# EUROPEAN PATENT SPECIFICATION

(11) **EP 0 852 341 B1**
(45) Date of publication and mention of the grant of the patent: **29.08.2001**
(21) Application number: 97100069.0
(22) Date of filing: 03.01.1997
(51) Int. Cl.: G03F 7/32, G03F 7/023, G03F 7/075

(54) **Method for the pattern-processing of photosensitive resin composition**
Verfahren zur Bebilderung einer photoempfindlichen Harzzusammensetzung
Procédé de production d'images sur une composition photosensible à base de résine

(43) Date of publication of application: 08.07.1998
(73) Proprietor: SUMITOMO BAKELITE COMPANY LIMITED, Tokyo 140 (JP)
(72) Inventor: Banba, Toshio, Utsunomiya-shi (JP); Takeda, Toshiro, Utsunomiya-shi (JP)
(74) Representative: Vossius, Volker, Dr.

(56) References cited:
- EP-A- 0 291 779
- EP-A- 0 413 559
- EP-A- 0 459 395
- EP-A- 0 493 923
- JP-A- 8 123 034

## Description

### BACKGROUND OF THE INVENTION

### Field of the Invention

This invention relates to a method for the pattern-processing of a photosensitive resin composition for obtaining a scum-free, high-resolution pattern.

### Prior Art

In a semiconductor industry, a photosensitive resin such as a photoresist, a photosensitive polyimide or the like has recently been often used in the preparation of a very fine circuit such as IC, LSI or the like or as an insulating film or protective film in a package requiring processing. The characteristic feature of the photosensitive resin consists in that a high precision resin pattern can be obtained by a relatively simple apparatus. In particular, a positive photoresist comprising as a base a phenol novolak resin using a diazoquinone or the like as a photosensitive agent enables the formation of a pattern excellent in resolution because it does not swell during developing. In addition, since the developer is an alkaline aqueous solution, the positive photoresist is excellent in an aspect of safety. As discussed above, the photosensitive resin has many features, and hence, has been often used in the production of fine circuits and the like of the above semiconductor. On the other hand, in a photosensitive, heat-resistant resin such as a photosensitive polyimide which is used in the insulating film or protective film of a semiconductor, a positive type photosensitive, heat-resistant resin having such features as high resolution, environmental pollution-free developer and the like has been developed similarly to the photoresist (see, for example, JP-A-64-60630, JP-B-1-46862 and the like) and has attracted attention as a resin for insulating film or protective film of a highly integrated semiconductor.

Most of the positive photosensitive resin compositions are composed of a combination of an alkali-soluble polymer with the above-mentioned diazoquinone compound as a photosensitive agent. In the unexposed portions, these quinonediazide compounds are insoluble in an alkaline aqueous solution; however, upon exposure, they cause a chemical reaction to become soluble in an alkaline aqueous solution. Accordingly, utilizing the difference in solubility between the exposed portion and the unexposed portion, the exposed portion is removed by an alkaline aqueous solution, whereby it becomes possible to prepare a coating film pattern composed of only the unexposed portion.

The alkaline aqueous solution used as a developer is generally an aqueous solution of tetramethylammonium hydroxide (referred to hereinafter as TMAH). When a photoresist comprising as a base a conventional phenol novolak resin is developed, a good development can be effected using an aqueous solution of this TMAH. However, in the case of a photosensitive resin composition comprising a polybenzoxazole precursor as stated in JP-B-1-46862 as a base, there is such a disadvantage that an undeveloped portion (scum) remains in the exposed portion which should be completely removed to deteriorate the resolution.

JP-A-8 123034 relates to a positive type resin composition having excellent adhesion to a substrate.

Claim 1 of JP-A-8 123034 discloses a positive type photosensitive resin composition corresponding in general terms essentially to the positive type photosensitive resin composition used in the method of the present invention.

In addition, the use of the photosensitive resin composition in a method of pattern-processing is disclosed.

EP-A- 0 493 923 relates to sensitizers which are extremely compatible with fluorinated hydroxy polyamides, are soluble in commonly used solvents and, in combination with fluorinated hydroxy polyamides, and other hydroxy resins such as hydroxy styrenes or Novolaks, provide photosensitive compositions which, when coated onto a suitable substrate, provide a uniform coating and develop well in light/dark regions.

In addition, EP-A-0 493 923 relates to a positive photosensitive composition comprising a photosensitizer composition according to claim 1 of EP-A-0 493 923 and a fluorinated hydroxy polyamide.

Thus, the photosensitive compositions according to EP-A-0 493 923 may be employed in a photoresist solution which can be applied to a substrate by any suitable method.

Suitable developing solutions for the radiation sensitive composition of
EP-A-0 493 923 are aqueous solutions of inorganic alkaline compounds. Such an alkaline solution can also contain certain organic solvents such as alcohols as well as surface active agent (sodium alkylnaphthalene sulfonate, sodiumlaurylsulfate, etc.).

However, neither JP-A-8 123034 nor EP-A-0 493 923 discloses the use of an alkylbenzenesulfonic acid as an anionic surfactant in the alkaline aqueous developing solution to obtain scum-free, high-resolution pattern.

### SUMMARY OF THE INVENTION

An object of this invention is to provide a method for the pattern-processing of a photosensitive resin composition giving a high resolution without causing a scum which has been caused in the conventional pattern processing.

Other objects and advantages of this invention will become apparent from the following description.

According to this invention, there is provided a method for the pattern-processing of a photosensitive resin composition, which comprises coating a positive photosensitive resin composition comprising a polyamide represented by the following formula (1) and a diazoquinone compound on a substrate, subjecting the same to prebaking and then to irradiation with a light and thereafter dissolving the exposed portions in an alkaline aqueous solution containing an alkylbenzensulfonic acid as an anionic surfactant to remove the same, thereby obtaining a pattern: 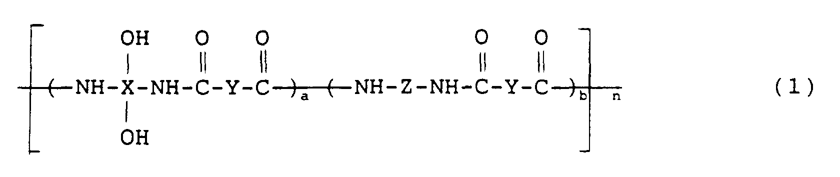 wherein X is a tetravalent aromatic group; Y is a divalent aromatic group; Z is 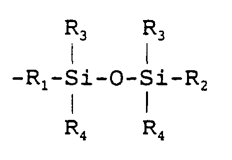 in which R₁ and R₂ are divalent organic groups and R₃ and R₄ are monovalent organic groups; a and b are mole fractions; a + b = 100 mole %; a = 60.0 - 100 mole %; b = 0 - 40.0 mole % and n = 2 - 500.

### DETAILED DESCRIPTION OF THE INVENTION

The polyamide represented by the formula (1) is composed of a bisaminophenol having the structure of X and a dicarboxylic acid having the structure of Y and when this polyamide is heated at about 300-400°C, ring-closure reaction is caused to convert the polyamide to a heat-resistant resin called polybenzoxazole. In general, a positive photosensitive resin composition is developed with an aqueous alkali solution. For example, a photoresist can be developed because the phenol novolak resin which is the base of the photoresist has phenolic hydroxyl groups. Similarly, a positive photosensitive resin comprising as a base a polyamide represented by the formula (1) can also be developed because the bisaminophenol having the structure of X has phenolic hydroxyl groups. However, this photosensitive resin is inferior in developability to the photoresist comprising as the base a phenol novolak resin and causes scum in the exposed portion, whereby the resolution is deteriorated.

This is considered to be because while the phenol novolak resin contains one hydroxyl group per one benzene ring, the polyamide represented by the formula (1) contains a hydroxyl group only in the amine moiety. In the case of a polyamide formed by replacing a part of the bisaminophenol having the structure of X by the siliconediamine having the structure of Z of the formula (1) for the purpose of improving the adhesiveness, the solubility of the resin becomes lower, and hence, more scum is caused and the resolution becomes very bad. However, when the resin composition is processed with the aqueous alkali solution containing an anionic surfactant of this invention, the scum is not caused at all. Although the cause has not been clarified, this is considered to be because the affinity between the resin and the developer is improved by the anionic surfactant.

In the polyamide (1) of this invention, X includes, for example, 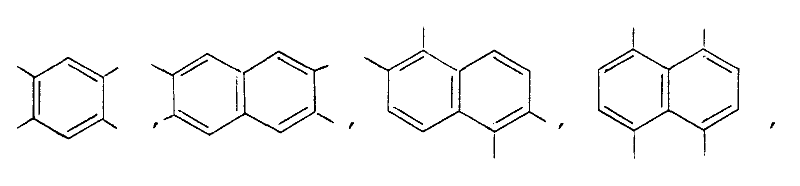 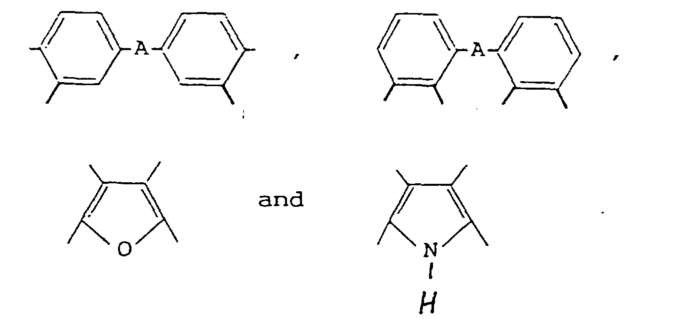 wherein A represents -CH₂-, -O-, -S-, -SO₂-, -CO-, -NHCO- or -C(CF₃)₂-; and the like, but is not limited thereto.

In the formula (1), Y includes, for example, 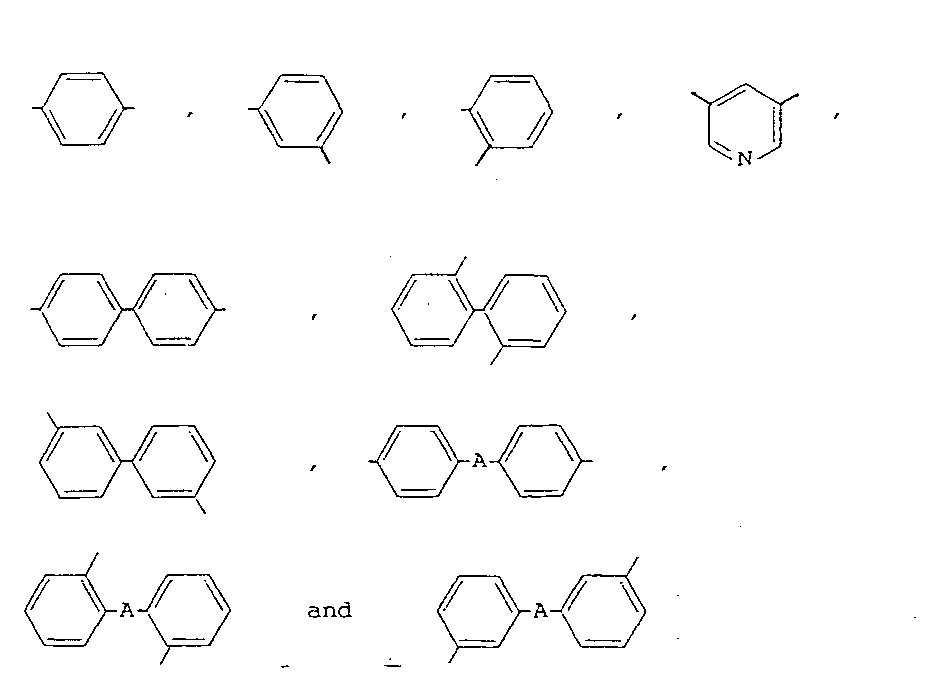 wherein A represents -CH₂-, -O-, -S-, -SO₂-, -CO-, -NHCO- or -C(CF₃)₂-; and the like, but is not limited thereto.

Moreover, in the formula (1), Z includes, for example, 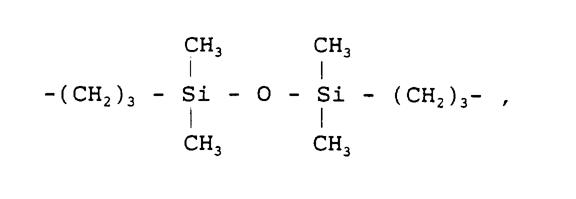 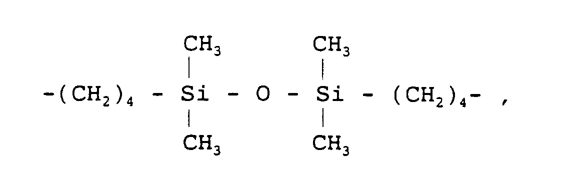 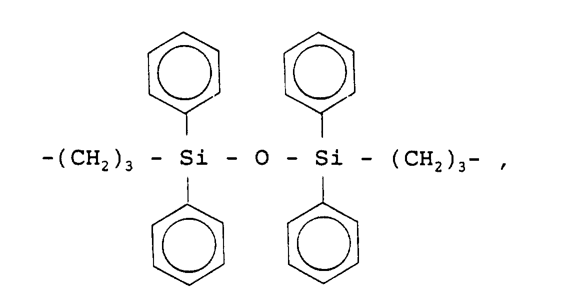 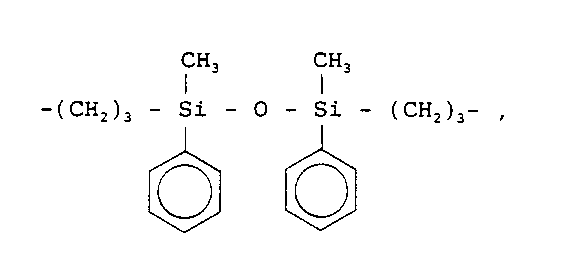 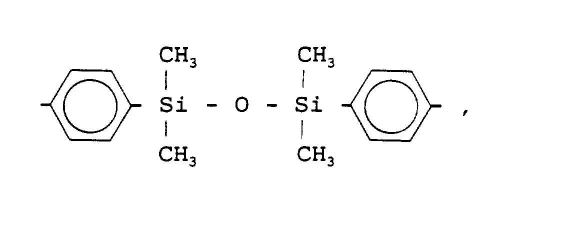 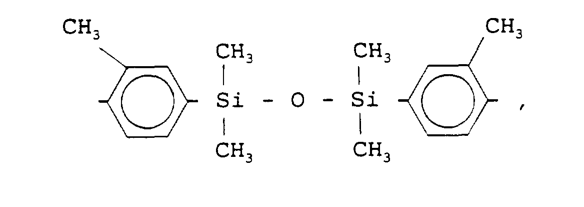 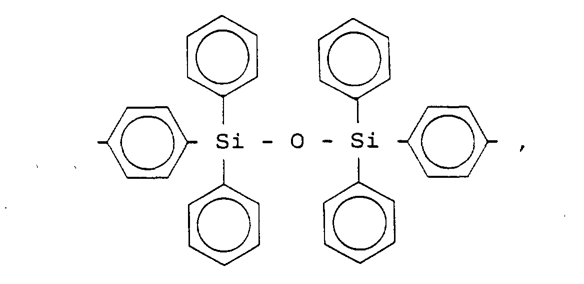 and the like, but is not limited thereto.

Z in the formula (1) is used when the adhesiveness to a substrate such as a silicon wafer is required, and can be used in such an amount that the proportion b is at most 40.0 mole %. When the proportion b exceeds 40 mole %, the solubility of the resin becomes very low and even when the pattern-processing method of this invention is used scum is caused and the pattern-processing becomes impossible.

Incidentally, when these X, Y and Z are used, each of them may be alone or in admixture of two or more.

The anionic surfactant used in this invention are alkylbenzenesulfonic acids and alkali metal salts of alkylbenzenesulfonic acids. Specific examples thereof include dodecylbenzenesulfonic acid and sodium dodecylbenzenesulfonate. Incidentally, the anionic surfactant referred to herein includes a compound which produces its alkali salt in an aqueous alkali solution to form an anionic surfactant.

The amount of the anionic surfactant contained in the alkaline aqueous solution which is the developer of this invention is preferably 0.1 to 10% by weight based on the total weight of the alkaline aqueous solution. When the amount is less than 0.1% by weight, scum tends to be caused and when the amount is more than 10% by weight, the film thickness loss in the unexposed portion becomes large and no good pattern is obtained.

The alkaline aqueous solution of this invention is for dissolving and removing the alkali-soluble polymer and must be an aqueous solution having dissolved therein an alkali compound. The alkali compound includes, for example, inorganic alkalis such as sodium hydroxide, potassium hydroxide, sodium carbonate, sodium silicate, sodium metasilicate, ammonia water and the like; primary amines such as ethylamine, n-propylamine and the like; secondary amines such as diethylamine, di-n-propylamine and the like; tertiary amines such as triethylamine, methyldiethylamine and the like; alcoholamines such as dimethylethanolamine, triethanolamine and the like; and quaternary ammonium salts such as tetramethylammonium hydroxide, tetraethylammonium hydroxide and the like. These may be used alone or in admixture of two or more. Among them, tetramethylammonium hydroxide is preferable. The concentration of the alkali compound is 0.1 to 10% by weight, preferably 1 to 3% by weight.

The photosensitive resin composition used in this invention comprises a polyamide, a diazoquinone compound and a solvent as the main components, and may, if necessary, contain a polyamic acid. The polyamic acid has a carboxyl group, so that the solubility is increased and the developing time can be shortened.

The diazoquinone compound used in this invention is a compound having a 1,2-benzoquinonediazide or 1,2-naphthoquinonediazide structure and is a known compound as disclosed in U.S. Patents 2,772,972; 2,797,213; and 3,669,658. It includes, for example, compounds represented by the following structural formulas: 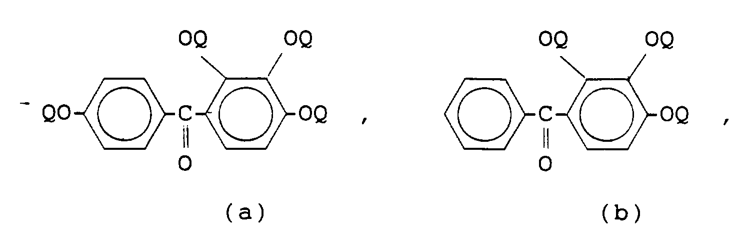 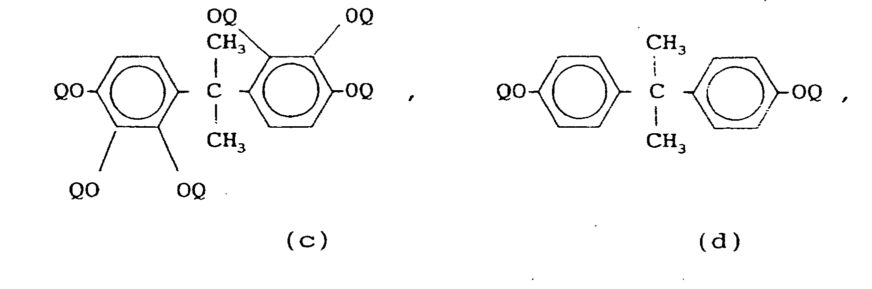 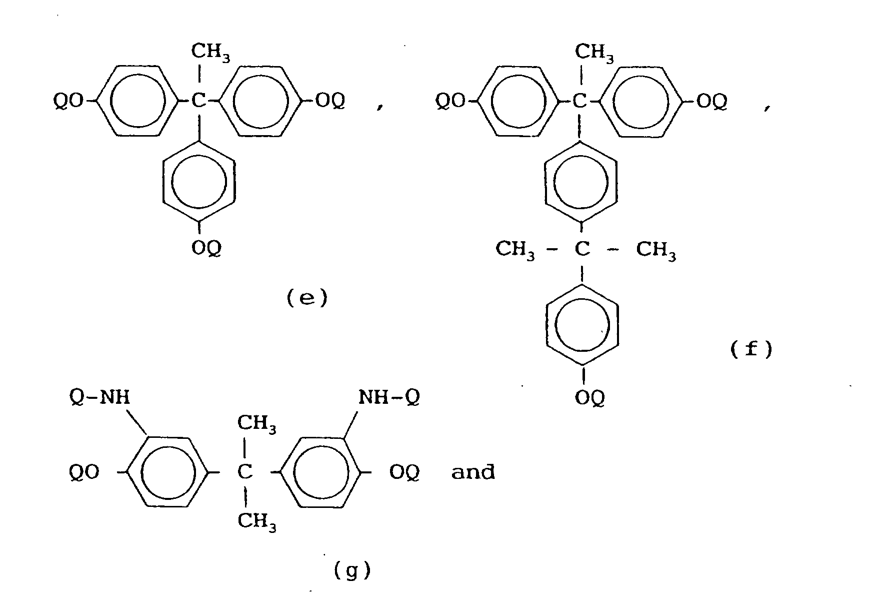 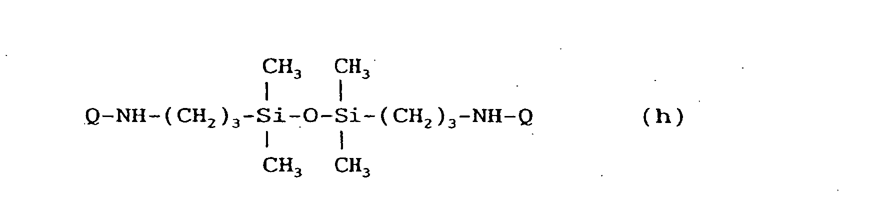 wherein Q is a hydrogen atom, 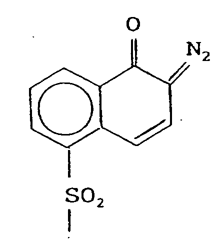 or 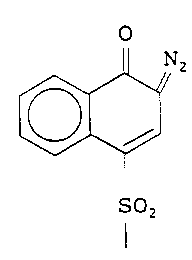 and at least one Q in each compound is 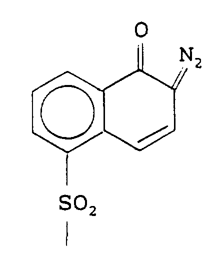 or 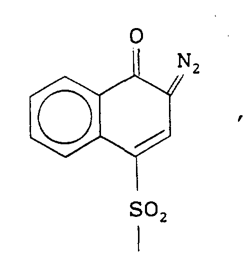 and the like.

Among the above compounds, preferable are (d), (e) (f) and (g), and (f) is particularly preferable.

The method of preparing a pattern comprises coating the composition on a suitable support, for example, a silicon wafer, a ceramic substrate, an aluminum substrate or the like. The coating can be carrier out by, for example, spin coating using a spinner, spray coating using a spray coater, immersion, printing, roll coating or the like. Subsequently, the coating film is dried at a temperature of about 60-180°C for a period of 1 to 10 minutes. The drying method is carried out using an oven, an infrared dryer, a hot plate or the like, and the hot plate is preferred in view of efficiency and easy temperature control. When this hot plate is used, the drying is preferably effected at a temperature of 80 to 130°C. When the temperature is lower than 80°C, the drying becomes insufficient and this is not desirable. When the temperature exceeds 130°C, the drying becomes excessive and this is not desirable. The drying is more preferably effected at a temperature of 100° to 120°C for a period of 2 to 4 minutes.

Subsequently, the dried coating film is irradiated with chemical beams in the desired pattern form. As the chemical beams, there can be used X rays, electron beams, ultraviolet rays, visible lights and the like, and those having a wavelength of 200 to 500 nm are particularly preferable. In order to obtain a higher resolution pattern, an i-line stepper utilizing a wavelength of 365 nm or a g-line stepper utilizing a wavelength of 436 nm are more preferably used.

### DESCRIPTION OF THE PREFERRED EMBODIMENTS

Examples are shown below to specifically explain this invention.

### Example 1

### Synthesis of polyamide

In 150 parts by weight of N,N-dimethylacetamide and 33.2 parts by weight (0.420 mole) of pyridine was dissolved 33.6 parts by weight (0.100 mole) of hexafluoro-2,2-bis(3-amino-4-hydroxyphenyl)-propane.

Subsequently, 21.3 parts by weight (0.105 mole) of terephthaloyl chloride dissolved in 100 parts by weight of cyclohexanone was dropped into the above solution at a temperature of -10° to -15°C over 30 minutes, after which the solution was stirred at room temperature for 4 hours to complete the reaction. The reaction mixture was filtered and then the filtrate was poured into water to precipitate the objective polymer (A) represented by the following formula (A). The precipitates were collected by filtration, sufficiently washed with water and then dried at 80°C in a vacuum for a whole day and night.

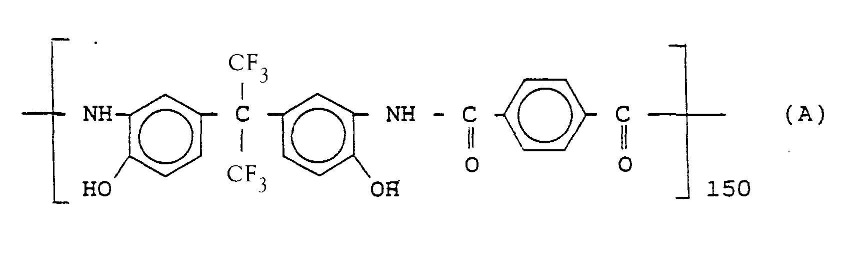

### Preparation of a photosensitive resin composition

In 200 parts by weight of N-methyl-2-pyrrolidone (referred to hereinafter as NMP) were dissolved 100 parts by weight of the synthesized polyamide (A) and 25 parts by weight of a diazoquinone compound (D) represented by the following structural formula (D), and thereafter, the resulting solution was filtered through a Teflon® filter of 0.2 µm to obtain a photosensitive resin composition:

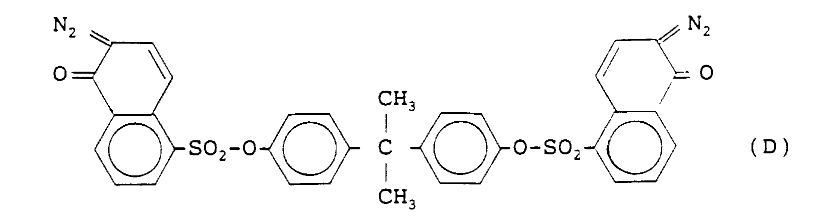

### Evaluation of photosensitivity

This photosensitive resin composition was spin coated on a silicon wafer and heated on a hot plate at 120°C for 3 minutes to evaporate the solvent, thereby forming a coating film having a thickness of 5 µm. This coating film was irradiated through a mask (test chart No. 1, a left pattern and a removed pattern were drawn in a width of 50-0.88 µm) manufactured by TOPPAN PRINTING CO., LTD. with ultraviolet rays from a high pressure mercury vapor lamp at a rate of 200 mJ/cm². The coating film obtained was developed with a developer consisting of 1.20 parts by weight of tetramethylammonium hydroxide, 98.30 parts by weight of pure water and 0.50 part by weight of dodecylbenzenesulfonic acid for 30 seconds by a paddle method, to dissolve and remove the coating film in the exposed portion, and then, the developer was washed off with water for 10 seconds. As a result, a scum-free pattern having a line width of 2.5 µm was obtained.

The film thickness loss during the development [(reduction in thickness due to development/thickness before development) x 100 (%), the smaller this value, the better] was 10% and good.

### Example 2

### Synthesis of polyamide

In 150 parts by weight of N,N-dimethylacetamide were dissolved 33.0 parts by weight (0.090 mole) of hexa-fluoro-2,2-bis(3-amino-4-hydroxyphenyl)propane and 2.5 parts by weight (0.010 mole) of 1,3-bis(3-aminopropyl)-1,1,3,3-tetramethyldisiloxane.

Subsequently, 21.3 parts by weight (0.105 mole) of terephthaloyl chloride dissolved in 100 parts by weight of cyclohexanone was dropped into the solution at a temperature of -10° to -15°C over 30 minutes, and the resulting mixture was then stirred at room temperature for 4 hours to complete the reaction. The reaction mixture was filtered and thereafter the solution was poured into water to precipitate the objective polymer (B) represented by the following formula (B). The precipitates were collected by filtration, sufficiently washed with water and then dried at 80°C in a vacuum for a whole day and night.

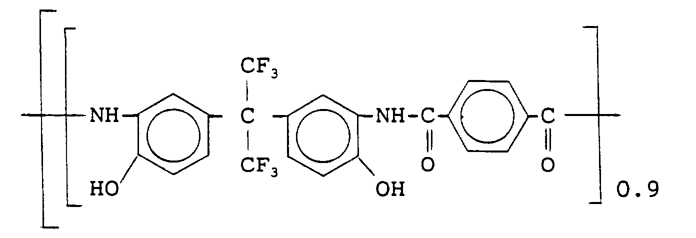

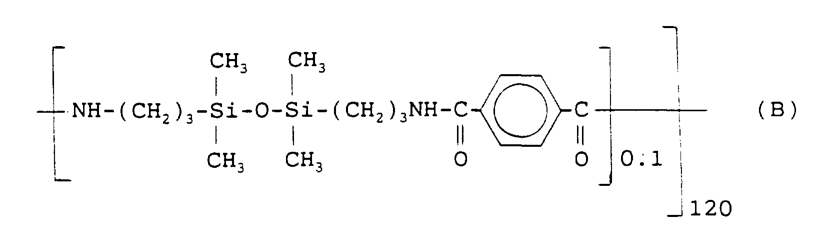

### Preparation of a photosensitive resin composition

In 200 parts by weight of NMP were dissolved 100 parts by weight of the synthesized polyamide (B) and 25 parts by weight of the same diazoquinone compound (D) as used in Example 1, and thereafter, the resulting solution was filtered through a Teflon filter of 0.2 µm to obtain a photosensitive resin composition.

### Evaluation of photosensitivity

Under the same conditions as in Example 1, spin coating, prebaking and exposure were conducted. Thereafter, development was effected with a developer consisting of 1.20 parts by weight of tetramethylammonium hydroxide, 93.80 parts by weight of pure water and 5.00 parts by weight of dodecylbenzenesulfonic acid for 60 seconds by a paddle method to dissolve and remove the coating film in the exposed portion and then the developer was washed off with water for 10 seconds. As a result, a scum-free pattern having a line width of 5 µm was obtained. The film thickness loss at this time was 8% and good.

### Example 3

### Synthesis of polyamide

In 400 parts by weight of NMP were dissolved 43.6 parts by weight (0.175 mole) of 1,3-bis(γ-aminopropyl)-1,1,3,3-tetramethyldisiloxane and 57.5 parts by weight (0.178 mole) of benzophenonetetracarboxylic acid dianhydride and the resulting solution was then stirred at room temperature for 7 hours. The reaction mixture was poured into water and the resulting precipitates were collected by filtration and then vacuum-dried at 80°C to obtain a polyamic acid (C) represented by the following structural formula (C):

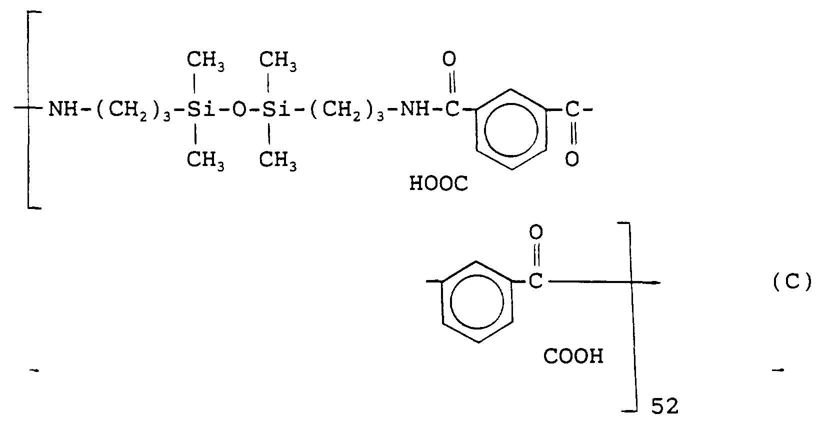

### Preparation of photosensitive resin composition

To 80 parts by weight of the polyamide (A) obtained in Example 1 and 20 parts by weight of the polyamic acid (C) was added 30 parts by weight of the same diazoquinone compound (D) as used in Example 1 to make a solution and the solution was filtered through a Teflon filter of 0.2 µm to obtain a photosensitive resin composition.

### Evaluation of photosensitivity

Under the same conditions as in Example 1, the spin coating, prebaking and exposure were carried out, and thereafter, development was conducted with a developer consisting of 1.20 parts by weight of tetramethylammonium hydroxide, 98.50 parts by weight of pure water and 0.30 part by weight of dodecylbenzenesulfonic acid for 20 seconds by a paddle method to dissolve and remove the coating film in the exposed portion, after which the developer was washed off with water for 10 seconds. As a result, a scum-free pattern having a line width of 2 µm was obtained. The film thickness loss at this time was 13% and good.

### Example 4

In the same manner as in Example 1, except that a diazoquinone compound (E) represented by the following structural formula (E) was substituted for the diazoquinone compound (D), evaluation was conducted, to obtain a scum-free pattern having a line width of 3 µm. The film thickness loss at this time was 9% and good.

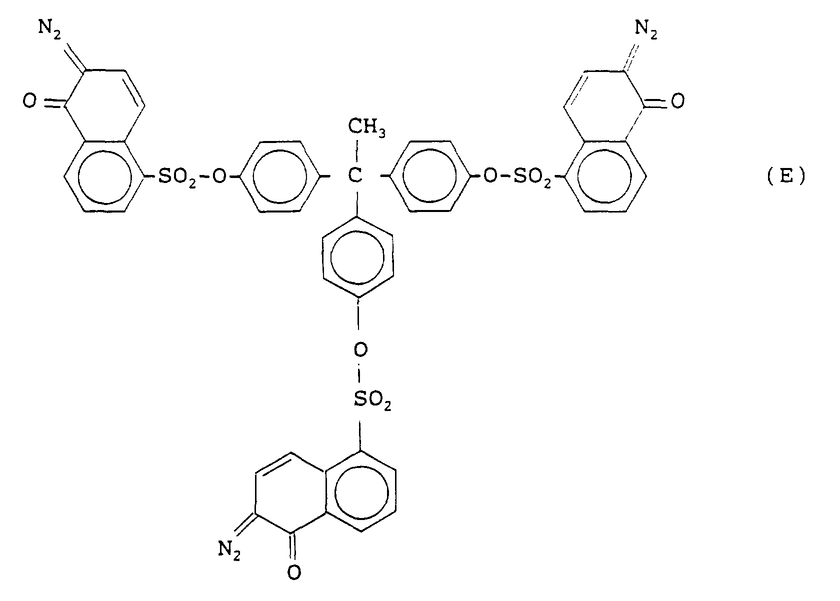

### Examples 5 and 6

The evaluation of photosensitivity was conducted in the same manner as in Example 1, except that the amount of dodecylbenzenesulfonic acid was changed to 0.1% by weight and 10% by weight, respectively.

### Example 7

### Synthesis of polyamide

In the same manner as in Example 1, except that 31.0 parts by weight (0.105 mole) of oxydibenzoyl chloride was substituted for 21.3 parts by weight (0.105 mole) of terephthaloyl chloride, a polyamide (F) represented by the following formula (F) was obtained.

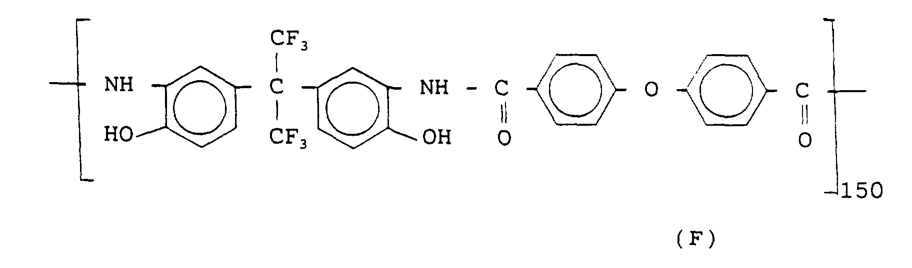

### Preparation of photosensitive composition

In the same manner as in Example 1, except that a diazoquinone compound (H) represented by the following formula (H) was substituted for the diazoquinone compound (D), a photosensitive composition of the polyamide (F) was prepared.

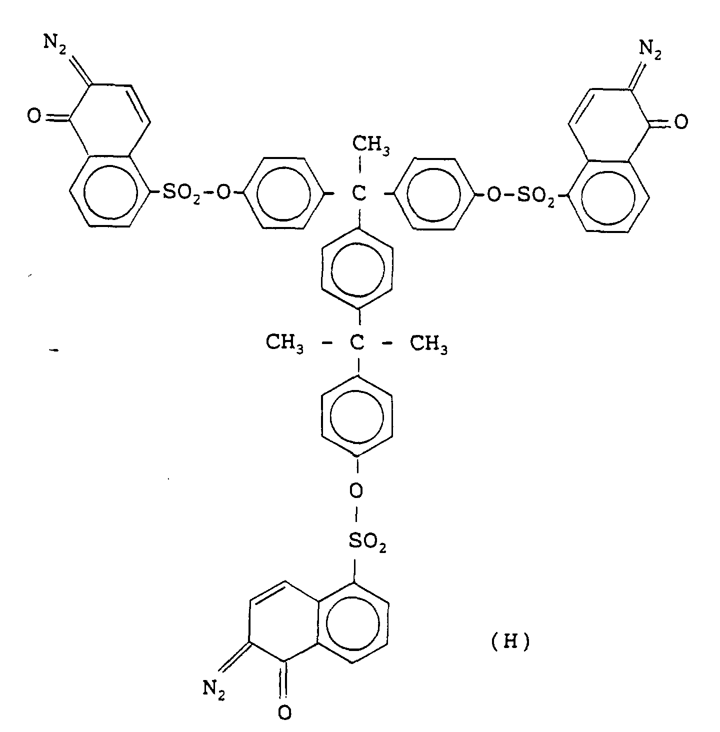

### Evaluation of photosensitivity

In the same manner as in Example 1, an evaluation of photosensitivity of the composition prepared above was conducted. As a result, a scum-free pattern having a line width of 2 µm was obtained. The film thickness loss at this time was 10% and good.

### Example 8

### Synthesis of polyamide

In the same manner as in Example 2, except that 31.0 parts by weight (0.105 mole) of oxydibenzoyl chloride was substituted for 21.3 parts by weight (0.105 mole) of terephthaloyl chloride, a polyamide (G) represented by the following formula (G) was obtained.

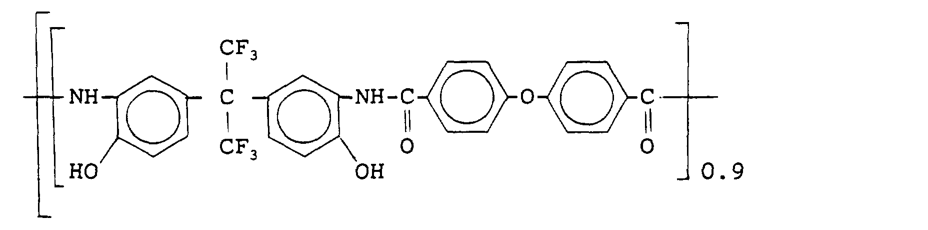

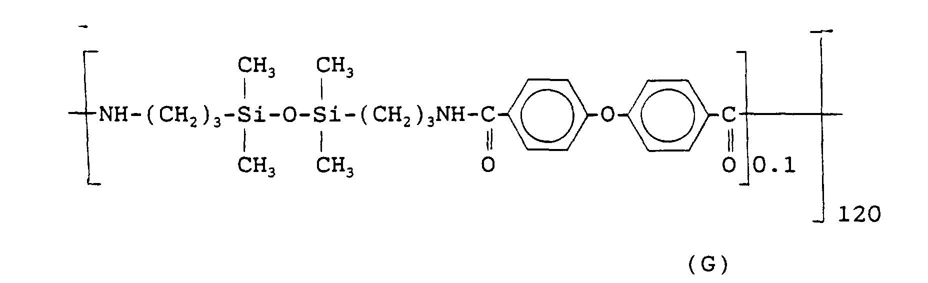

### Preparation of photosensitive composition

In the same manner as in Example 1, except that a diazoquinone compound (H) as used in Example 7 was substituted for the diazoquinone compound (D), a photosensitive composition of the polyamide (G) was prepared.

### Evaluation of photosensitivity

In the same manner as in Example 1, an evaluation of photosensitivity of the composition prepared above was conducted. As a result, a scum-free pattern having a line width of 3 µm was obtained. The film thickness loss at this time was 11% and good.

### Comparative Example 1

The same evaluation as in Example 1 was conducted, except that the developer was replaced by a developer consisting of 1.20 parts by weight of tetramethylammonium hydroxide and 98.80 parts by weight of pure water and not containing the dodecylbenzenesulfonic acid.

### Comparative Example 2

The same evaluation as in Example 2 was conducted, except that the developer was replaced by a developer consisting of 2.00 parts by weight of tetramethylammonium hydroxide and 98.00 parts by weight and not containing the dodecylbenzenesulfonic acid.

### Example 9

The same evaluation as in Example 1 was conducted, except that the developer was replaced by a developer consisting of 1.20 parts by weight of tetramethylammonium hydroxide, 86.80 parts by weight of pure water and 12.00 parts by weight of dodecylbenzenesulfonic acid.

### Example 10

The same evaluation as in Example 1 was conducted, except that the developer was replaced by a developer consisting of 1.20 parts by weight of tetramethylammonium hydroxide, 98.75 parts by weight of pure water and 0.05 part by weight of dodecylbenzenesulfonic acid.

The results obtained in the Examples and the Comparative Examples are shown in Table 1.

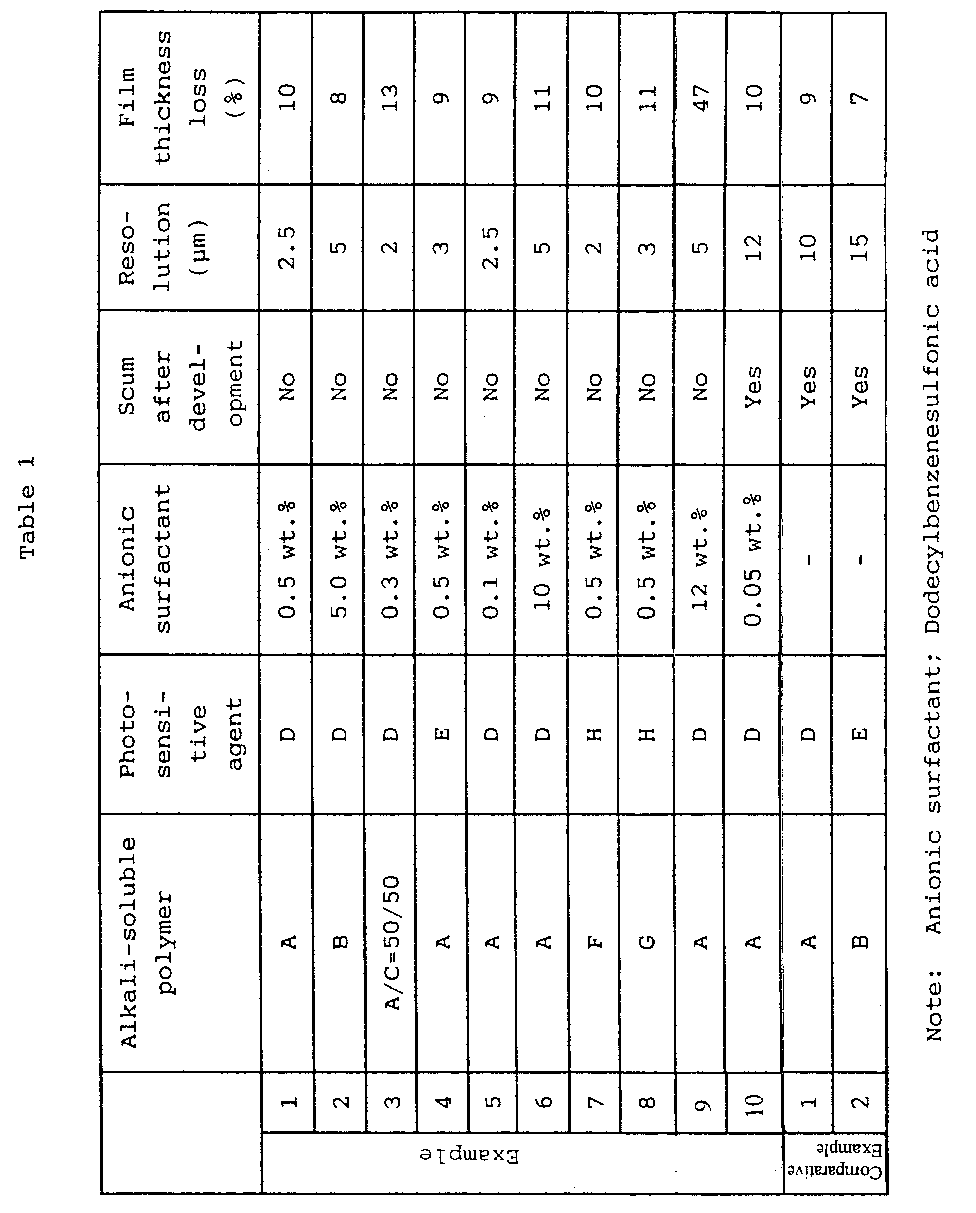

## Claims

1. A method for the pattern-processing of a photosensitive resin composition, which comprises coating on a substrate a positive photosensitive resincomposition comprising a polyamide represented by the following formula (1) and a diazoquinone compound: 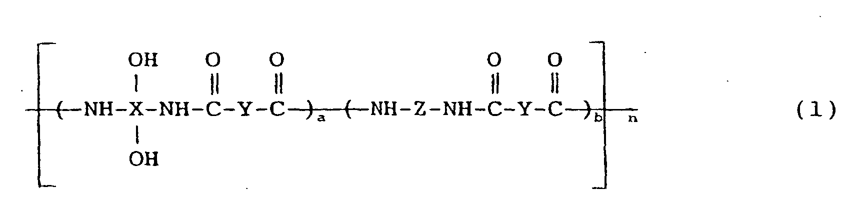 wherein X is a tetravalent aromatic group; Y is a divalent aromatic group; Z is 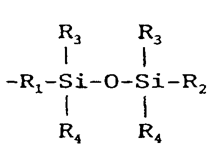 in which R₁ and R₂ are divalent organic groups and R₃ and R₄ are monovalent organic groups; a and b represent mole fractions; a + b = 100%; a = 60.0-100 mole %; b = 0-40.0 mole % and n = 2-500, subjecting the same to prebaking and then to irradiation with a light, thereafter dissolving the exposed portion in an alkaline aqueous solution containing an alkylbenzenesulfonic acid as an anionic surfactant to remove the same, thereby obtaining a scum-free, high resolution pattern.

2. The pattern-processing method according to Claim 1, wherein the alkylbenzenesulfonic acid is dodecylbenzenesulfonic acid.

3. The pattern-processing method according to Claim 1, wherein the amount of the anionic surfactant contained in the alkaline aqueous solution is 0.1-10% by weight based on the total weight of the alkaline aqueous solution.

4. The pattern-processing method according to Claim 1, wherein the alkaline aqueous solution is an aqueous solution of sodium hydroxide, potassium hydroxide, sodium carbonate, sodium silicate, sodium metasilicate, ammonia water, ethylamine, n-propylamine, diethylamine, di-n-propylamine, triethylamine, methyldiethylamine, dimethylethanolamine, triethanolamine or tetraethylammonium hydroxide.

5. The pattern-processing method according to Claim 4, wherein the alkaline aqueous solution is an aqueous solution of tetraethylammonium hydroxide.

6. The pattern-processing method according to Claim 1, wherein X in the formula (1) representing a polyamide is a group represented by one of the following structural formulas: 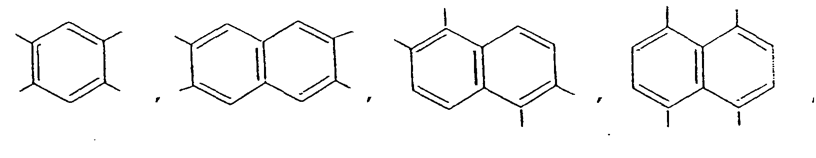 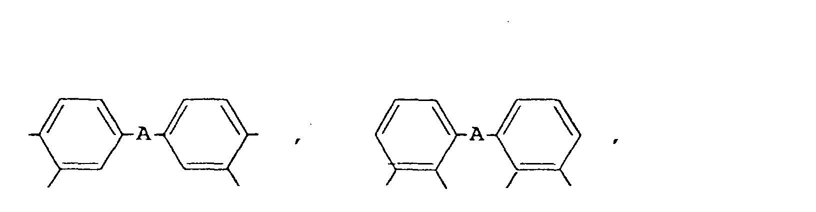 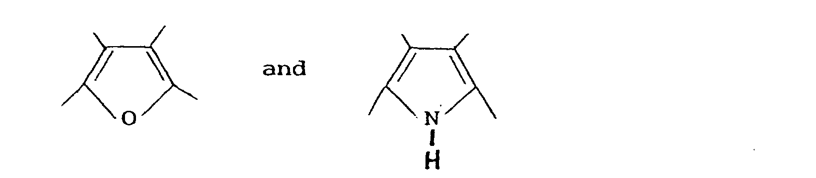 wherein A represents -CH₂-, -O-, -S-, -SO₂-, -CO-, -NHCO- or -C(CF₃)₂-.

7. The pattern-processing method according to Claim 1, wherein Y in the formula (1) representing a polyamide is a group represented by one of the following structural formulas: 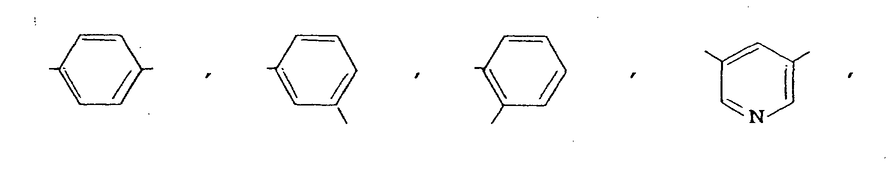 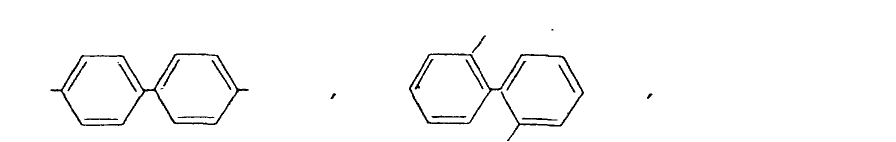 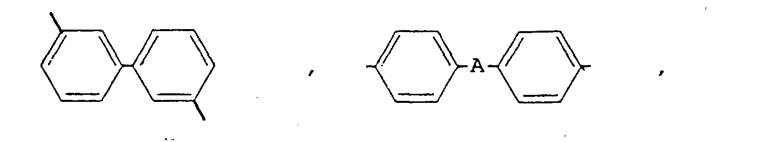 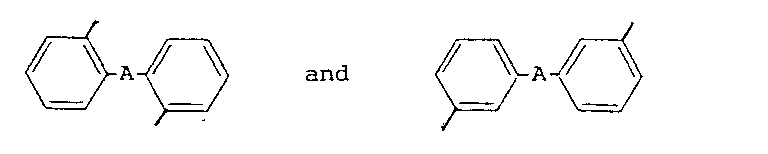 wherein A represents -CH₂-, -O-, -S-, -SO₂-, -CO-, -NHCO- or -C(CF₃)₂-.

8. The pattern-processing method according to Claim 1, wherein Z in the formula (1) representing a polyamide is a group represented by one of the following structural formulas:

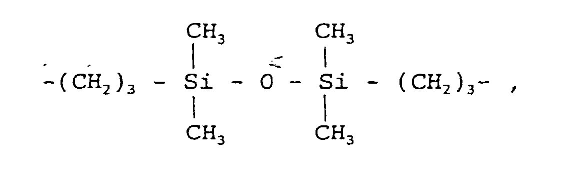

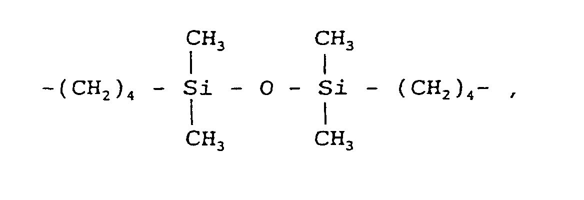

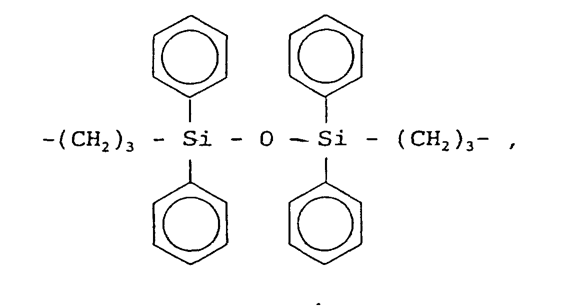

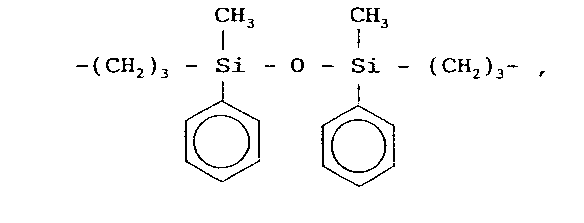

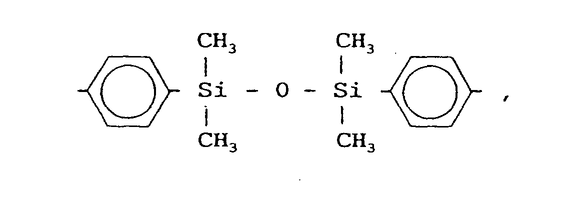

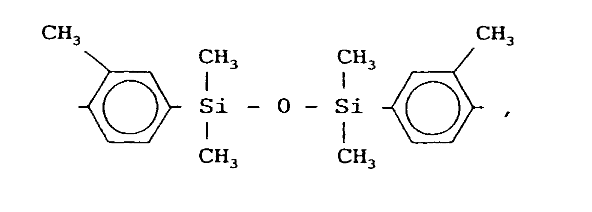

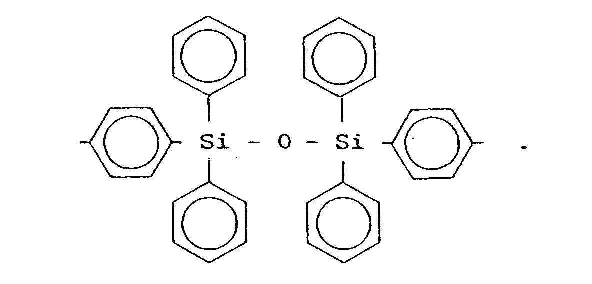

9. The pattern-processing method according to Claim 1, wherein the diazoquinone compound is a compound represented by one of the following structural formulas: 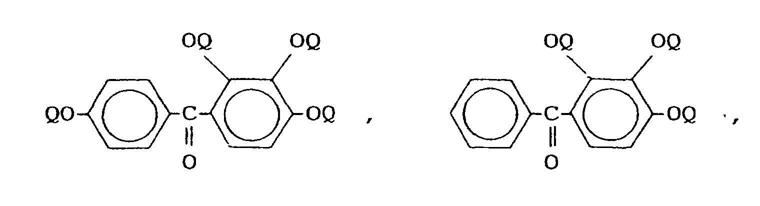 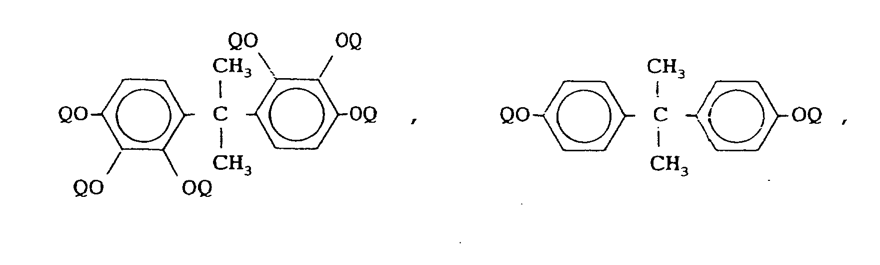 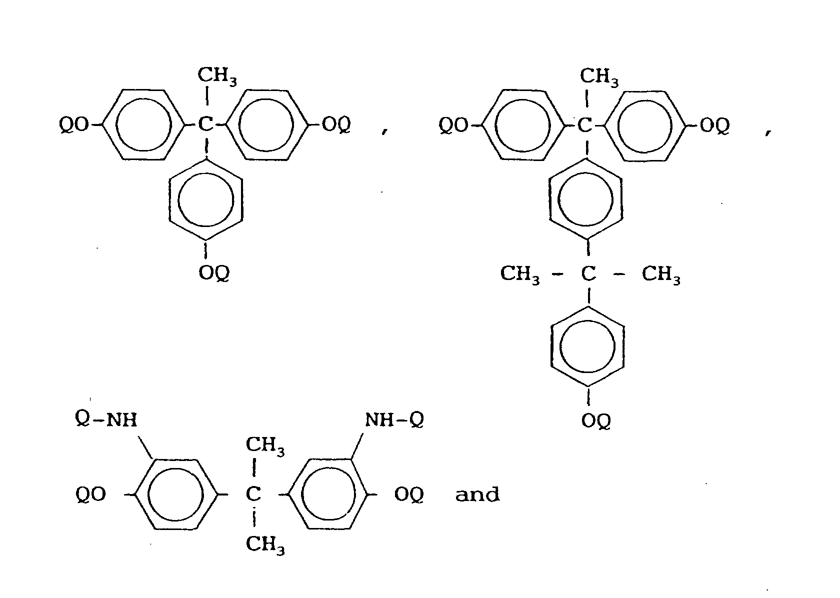 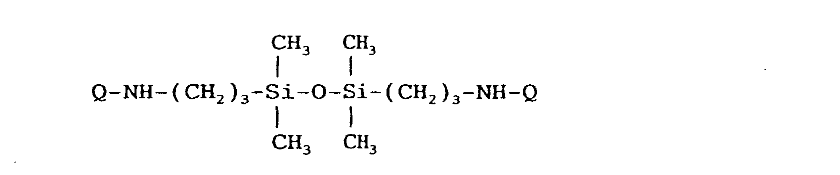 wherein Q is a hydrogen atom, 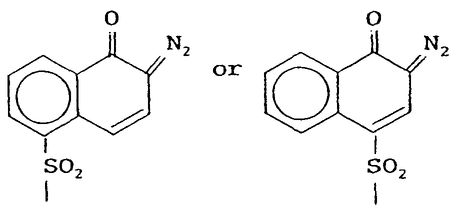 and at least one Q in each of the above compounds is

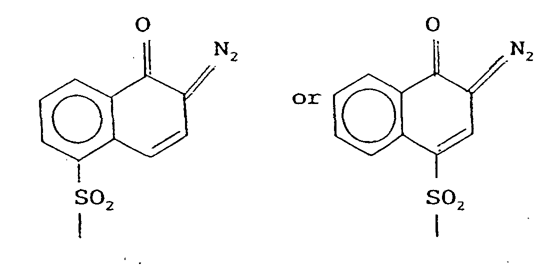

10. The pattern-processing method according to Claim 1, wherein the polyamide has any one of the following structural formulas: 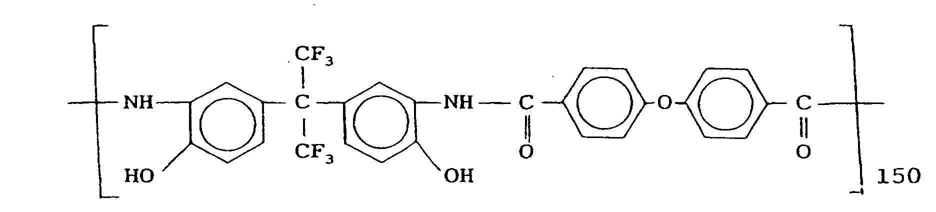 and

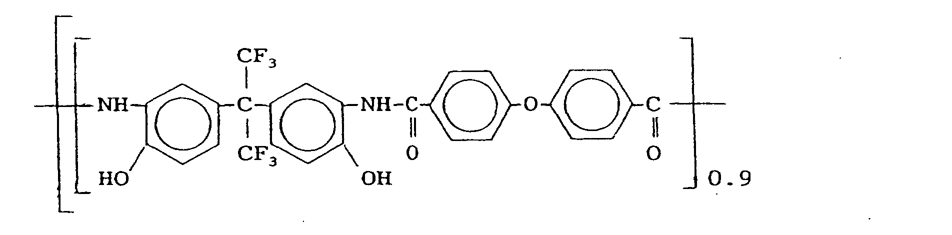

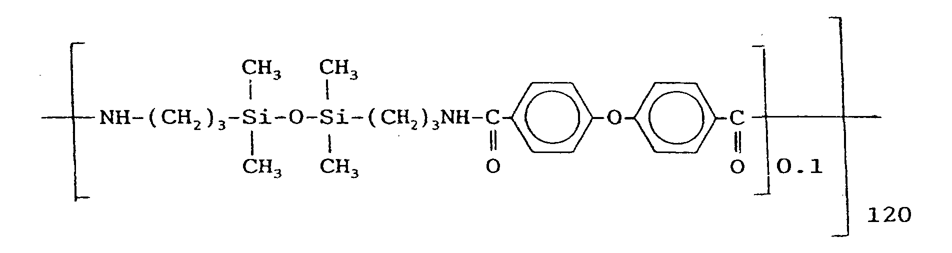

11. The pattern-processing method according to Claim 1, wherein the diazoquinone compound has any one of the following structural formulas: 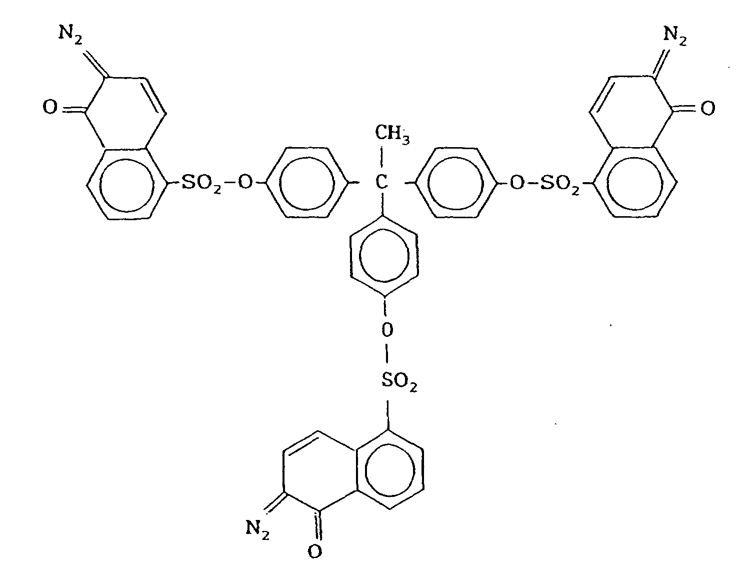 and

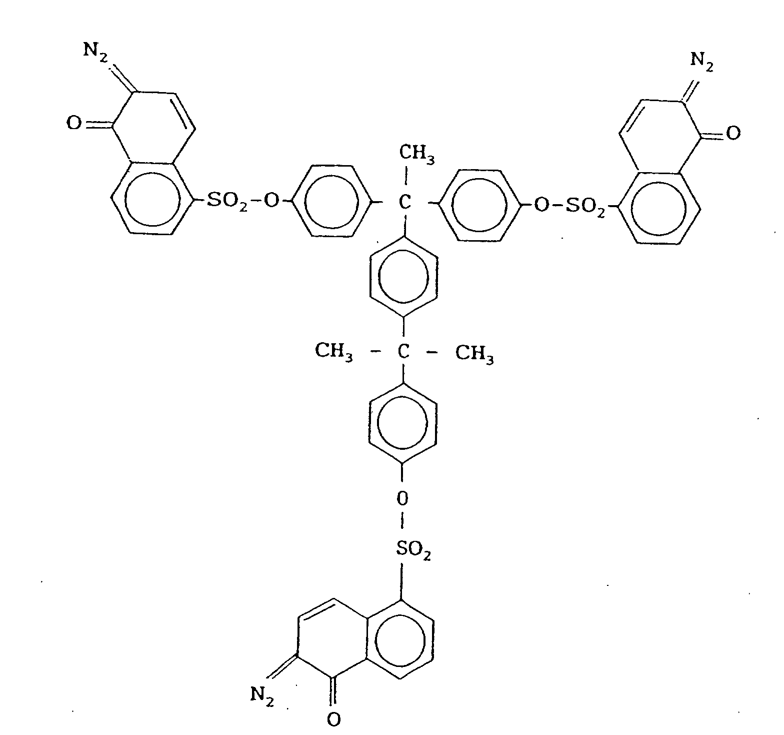

## Patentansprüche

1. Ein Verfahren zur Musterentwicklung einer lichtempfindlichen Harzzusammensetzung, umfassend das Aufbringen einer lichtempfindlichen Positivharzzusammensetzung auf einen Träger, wobei die lichtempfindliche Positivharzzusammensetzung ein Polyamid der nachstehenden Formel (1) und eine Diazochinonverbindung umfasst 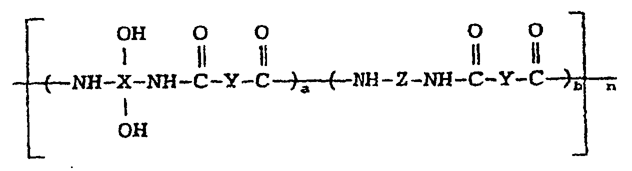 worin X eine tetravalente aromatische Gruppe, Y eine divalente aromatische Gruppe, Z die Gruppe 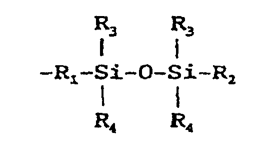 ist, worin R₁ und R₂ divalente organische Gruppen und R₃ und R₄ monovalente organische Gruppen sind, a und b Stoffmengenanteile darstellen, a + b = 100 %, a = 60,0-100 mol-%, b = 0-40,0 mol-% sind und n = 2-500 ist, Vorhärten der lichtempfindlichen Positivharzzusammensetzung und anschließend Belichten mit Licht, danach Lösen des belichteten Abschnitts in einer wässrigen alkalischen Lösung, die eine Alkylbenzolsulfonsäure als anionisches Tensid enthält, um diesen zu entfernen, wobei ein rückstandsfreies, hochaufgelöstes Muster erhalten wird.

2. Musterentwicklungsverfahren nach Anspruch 1, wobei die Alkylbenzolsulfonsäure Dodecylbenzolsulfonsäure ist.

3. Musterentwicklungsverfahren nach Anspruch 1, wobei die Menge des in der wässrigen alkalischen Lösung enthaltenen anionischen Tensids 0,1 bis 10 Gew.-% bezogen auf das Gesamtgewicht der wässrigen alkalischen Lösung beträgt.

4. Musterentwicklungsverfahren nach Anspruch 1, wobei die wässrige alkalische Lösung eine wässrige Lösung von Natriumhydroxid, Kaliumhydroxid, Natriumcarbonat, Natriumsilicat, Natriummetasilicat, Ammoniakwasser, Ethylamin, n-Propylamin, Diethylamin, Di-n-propylamin, Triethylamin, Methyldiethylamin, Dimethylethanolamin, Triethanolamin oder Tetraethylammoniumhydroxid ist.

5. Musterentwicklungsverfahren nach Anspruch 4, wobei die wässrige alkalische Lösung eine wässrige Lösung von Tetraethylammoniumhydroxid ist,

6. Musterentwicklungsverfahren nach Anspruch 1, wobei X in der ein Polyamid darstellenden Formel (1) eine Gruppe ist, die durch eine der nachstehenden Strukturformeln dargestellt ist: 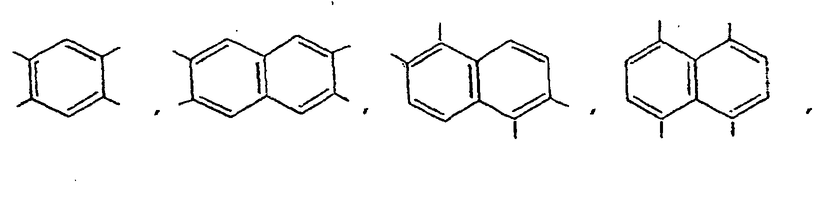 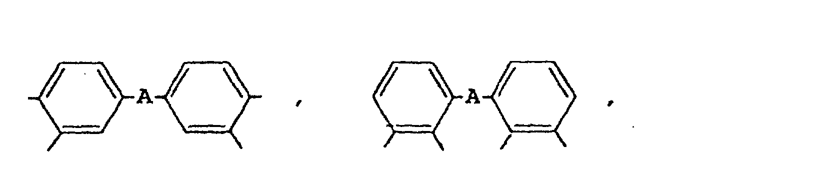 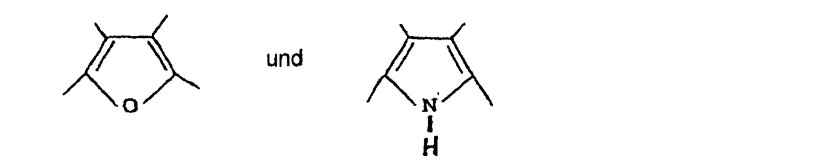 worin A die Gruppen -CH₂-, -O-, -S-, -SO₂-, -CO-, -NHCO- oder -C(CF₃)₂- darstellt.

7. Musterentwicklungsverfahren nach Anspruch 1, wobei Y in der ein Polyamid darstellenden Formel (1) eine Gruppe ist, die durch eine der nachstehenden Strukturformeln dargestellt ist: 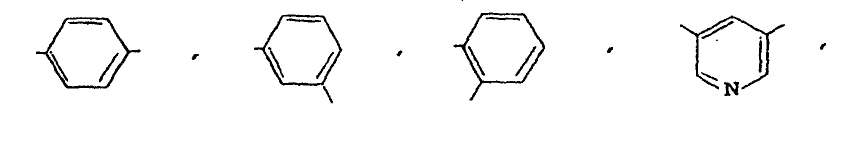 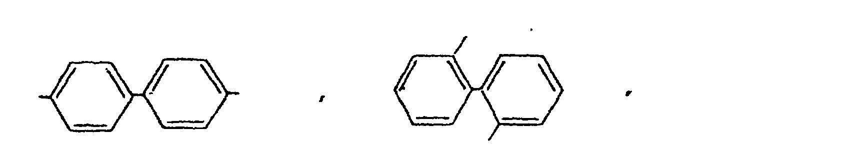 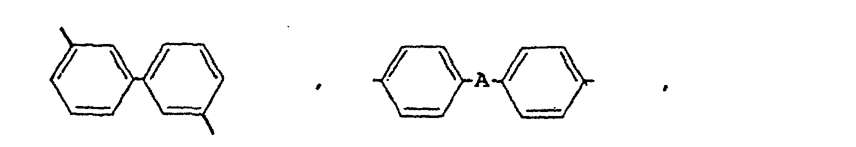 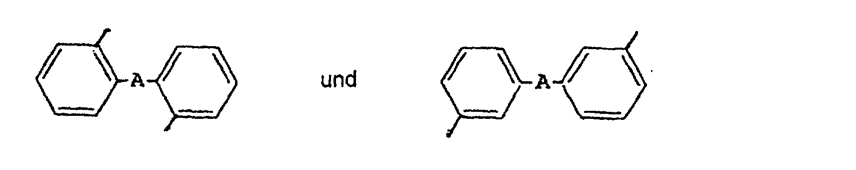 worin A die Gruppen -CH₂-, -O-, -S-, -SO₂-, -CO-, -NHCO- oder -C(CF₃)₂- darstellt.

8. Musterentwicklungsverfahren nach Anspruch 1, wobei Z in der ein Polyamid darstellenden Formel (1) eine Gruppe ist, die durch eine der nachstehenden Strukturformeln dargestellt ist:

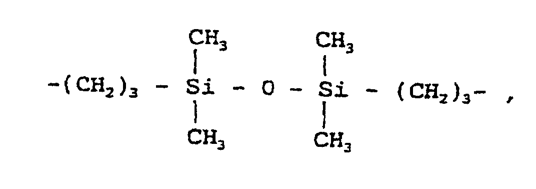

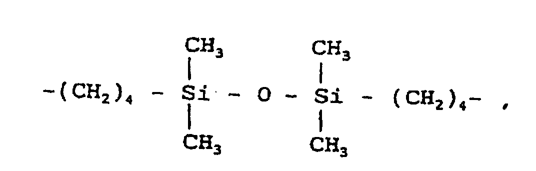

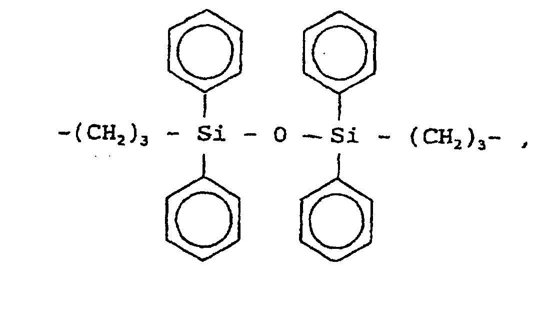

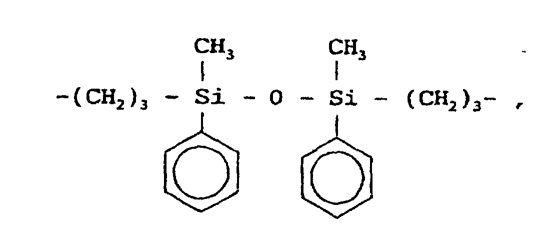

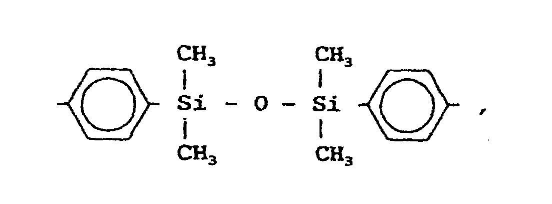

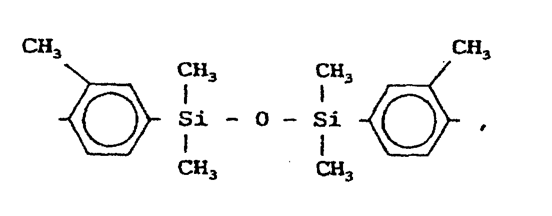

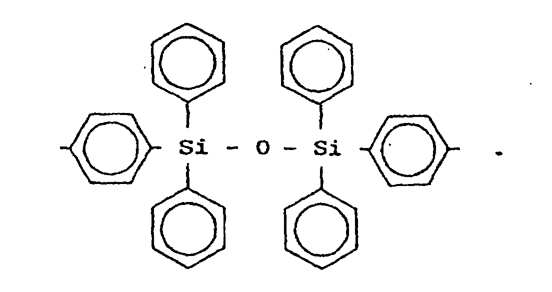

9. Musterentwicklungsverfahren nach Anspruch 1, wobei die Diazochinonverbindung eine Verbindung ist, die durch eine der nachstehenden Strukturformeln dargestellt ist: 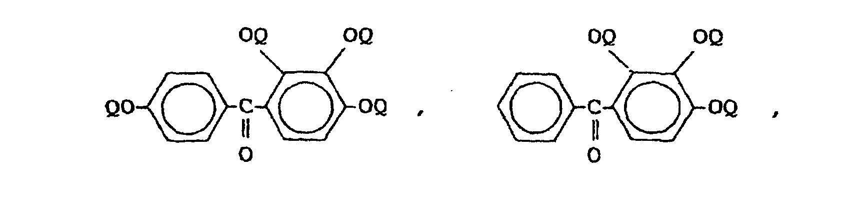 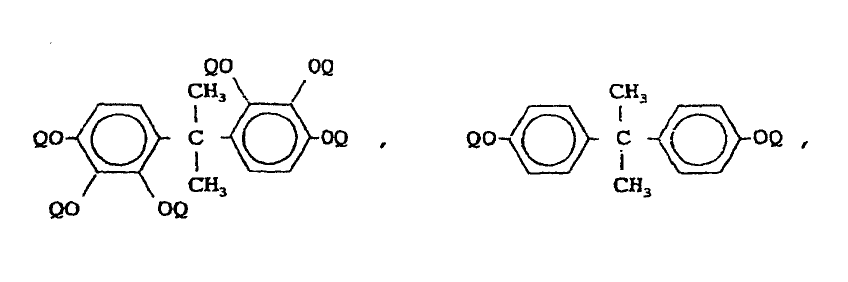 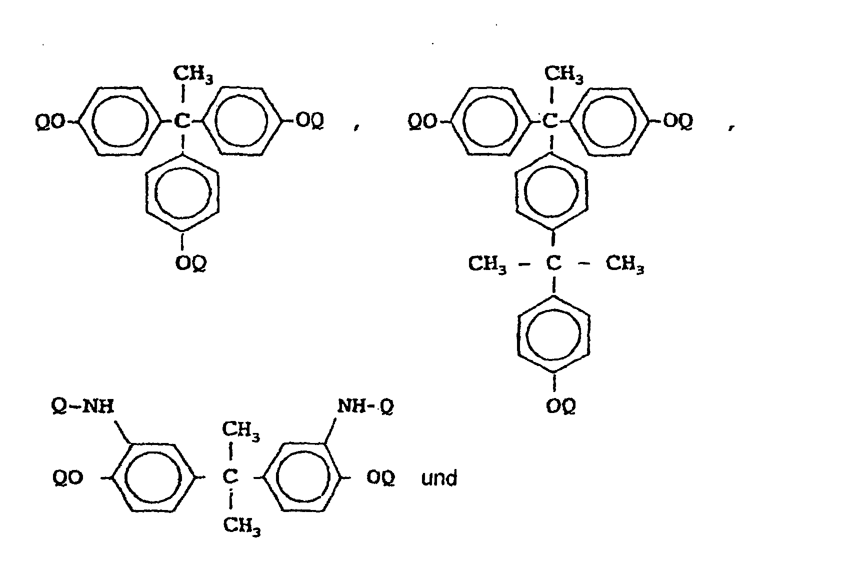 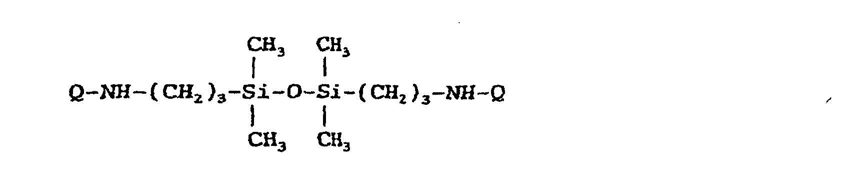 worin Q ein Wasserstoffatom, die Gruppe 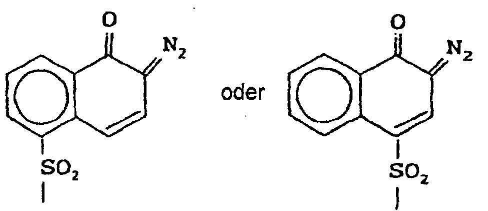 ist und wobei mindestens eine der Gruppen Q in jeder der vorstehenden Verbindungen die Gruppe 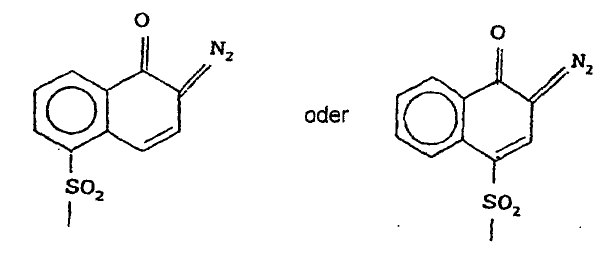 ist.

10. Musterentwicklungsverfahren nach Anspruch 1, wobei das Polyamid eine der nachstehenden Strukturformeln hat: 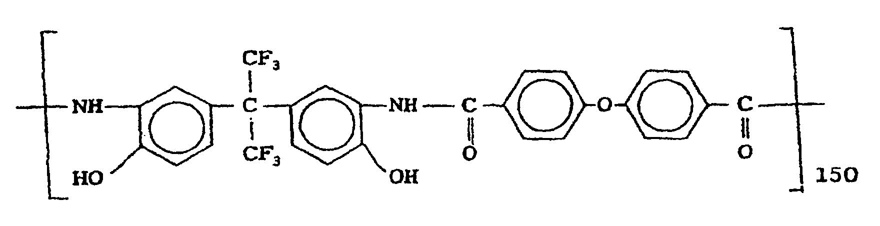 und

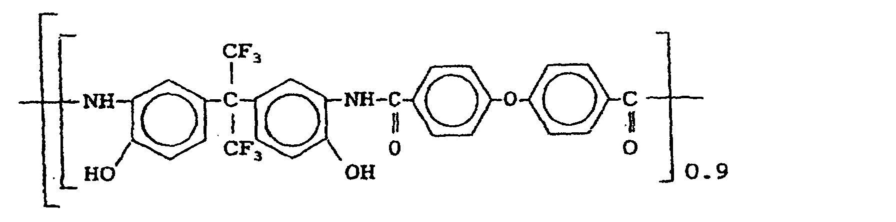

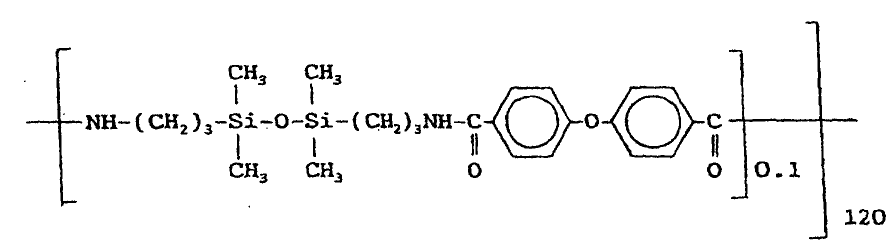

11. Musterentwicklungsverfahren nach Anspruch 1, wobei die Diazochinonverbindung eine der nachstehenden Strukturformeln hat: 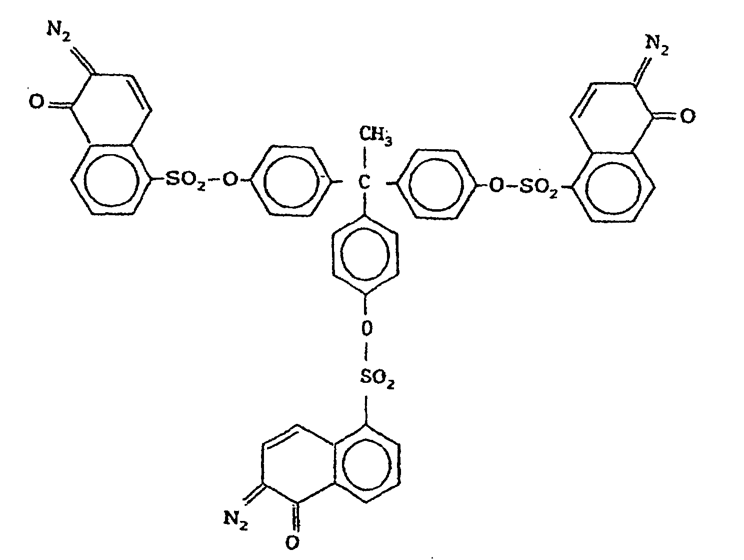 und

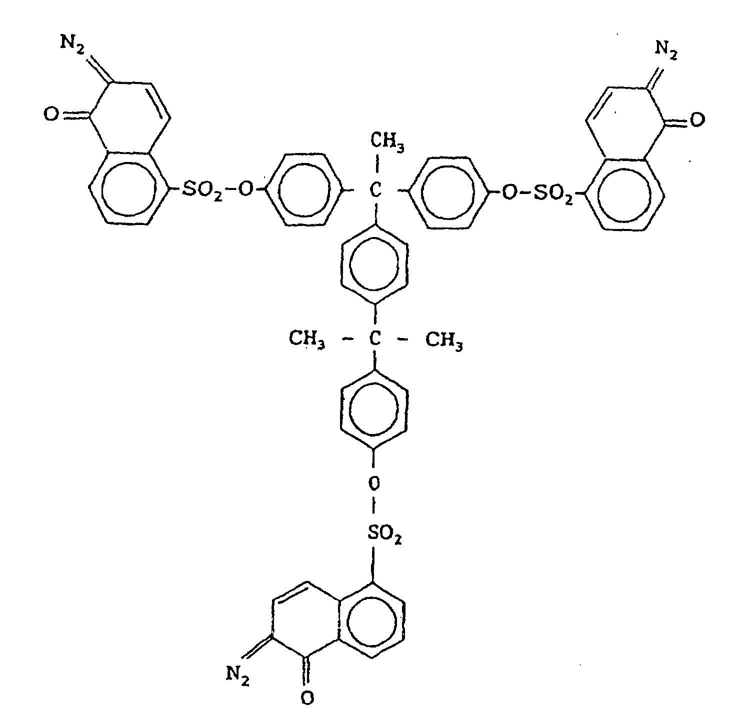

## Revendications

1. Procédé de traitement pour former un motif dans une composition de résine photosensible, qui comprend le fait de revêtir un substrat avec une composition de résine photosensible positive comprenant un polyamide représenté par la formule (1) suivante et un composé diazoquinone: 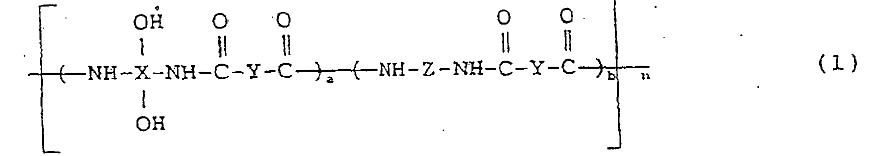 dans laquelle X est un groupe aromatique tétravalent; Y est un groupe aromatique divalent; Z est le groupe 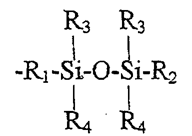 dans lequel R₁ et R₂ sont des groupes organiques divalents et R₃ et R₄ sont des groupes organiques monovalents; a et b représentent des fractions molaires; a + b = 100%; a = 60,0-100 % en moles; b = 0-40,0% en moles et n = 2-500, le fait de soumettre ledit substrat à un chauffage préalable, puis de l'irradier avec une lumière, ensuite de dissoudre la partie exposée dans une solution aqueuse alcaline contenant un acide alkylbenzènesulfonique en tant qu'agent tensioactif anionique pour l'éliminer, afin d'obtenir un motif haute résolution sans bavure.

2. Procédé de traitement pour former un motif selon la revendication 1, dans lequel l'acide alkylbenzènesulfonique est l'acide dodécylbenzènesulfonique.

3. Procédé de traitement pour former un motif selon la revendication 1, dans lequel la quantité du tensioactif anionique contenue dans la solution aqueuse alcaline est de 0,1-10% en poids par rapport au poids total de la solution aqueuse alcaline.

4. Procédé de traitement pour former un motif selon la revendication 1, dans lequel la solution aqueuse alcaline est une solution aqueuse d'hydroxyde de sodium, d'hydroxyde de potassium, de carbonate de sodium, de silicate de sodium, de métasilicate de sodium, d'eau ammoniacale, d'éthylamine, de n-propylamine, de diéthylamine, de di-n-propylamine, de triéthylamine, de méthyldiéthylamine, de diméthyléthanolamine, de triéthanolamine ou d'hydroxyde de tétraéthylammonium.

5. Procédé de traitement pour former un motif selon la revendication 4, dans lequel la solution aqueuse alcaline est une solution aqueuse d'hydroxyde de tétraéthylammonium.

6. Procédé de traitement pour former un motif selon la revendication 1, dans lequel X, dans la formule (1) représentant un polyamide, est un groupe représenté par une des formules développées suivantes: 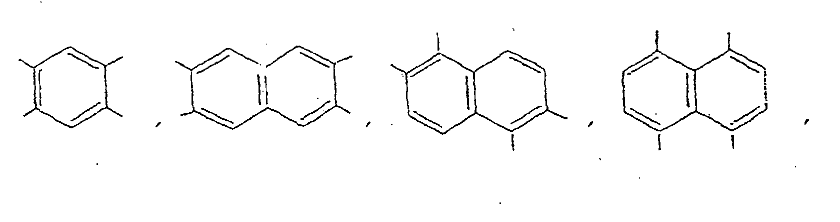 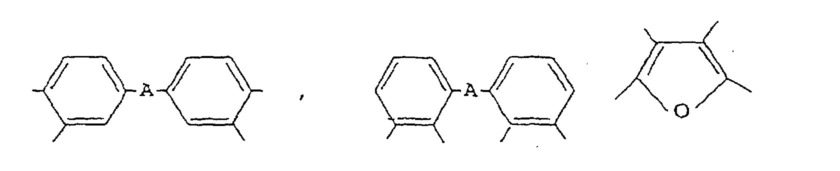 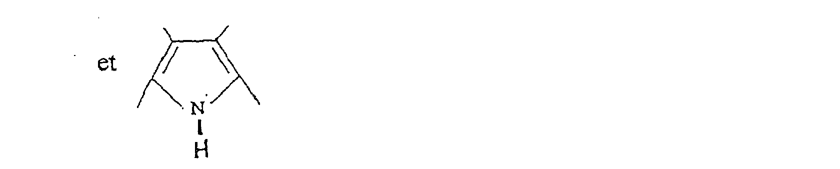 dans lesquelles A représente -CH₂-, -O-, -S-, -SO₂-, -CO-, -NHCO- ou -C(CF₃)₂-.

7. Procédé de traitement pour former un motif selon la revendication 1, dans lequel Y, dans la formule (1) représentant un polyamide, est un groupe représenté par une des formules développées suivantes: 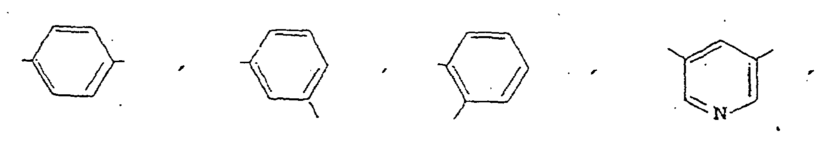 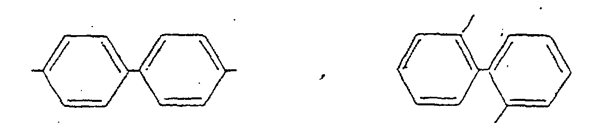 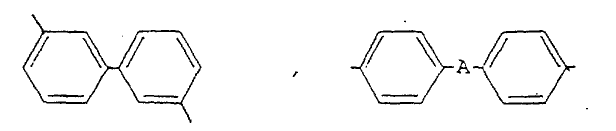 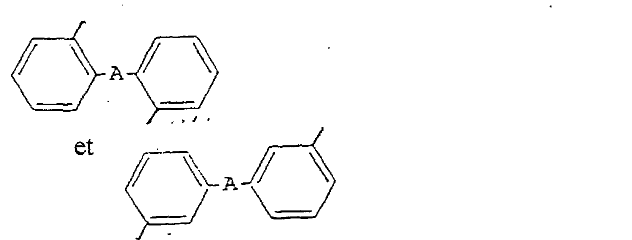 dans lesquelles A représente -CH₂-, -O-, -S-, -SO₂-, -CO-, -NHCO- ou -C(CF₃)₂-.

8. Procédé de traitement pour former un motif selon la revendication 1, dans lequel Z, dans la formule (1) représentant un polyamide, est un groupe représenté par une des formules développées suivantes:

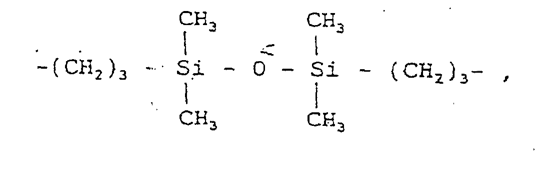

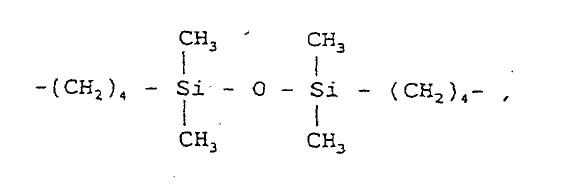

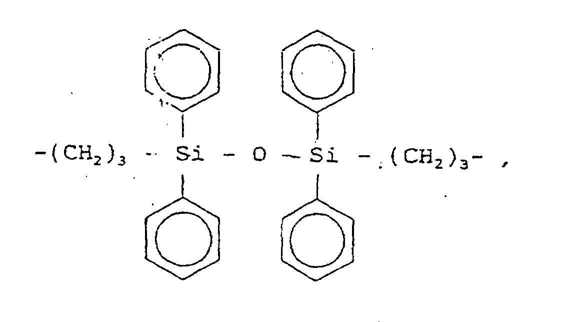

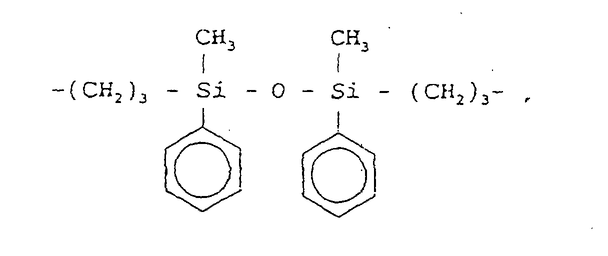

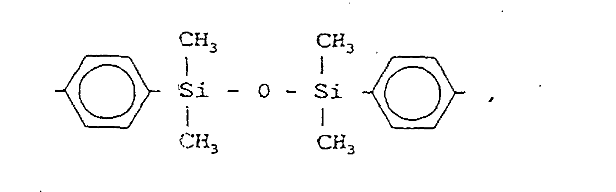

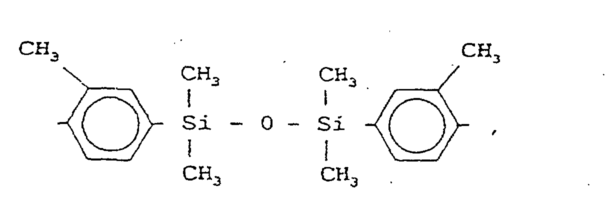

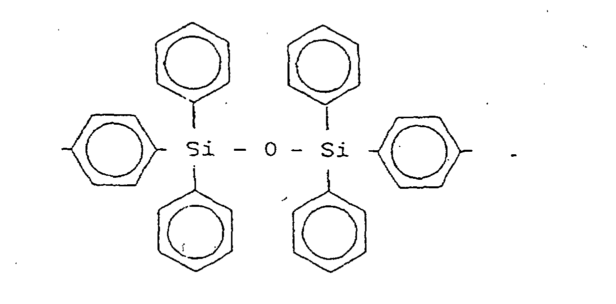

9. Procédé de traitement pour former un motif selon la revendication 1, dans lequel le composé diazoquinone est un composé représenté par une des formules développées suivantes: 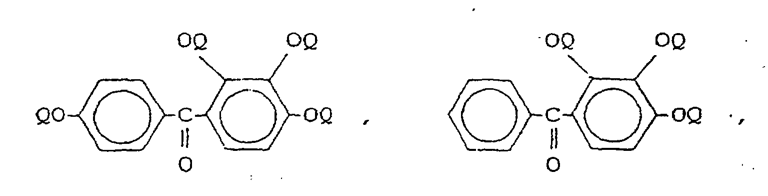 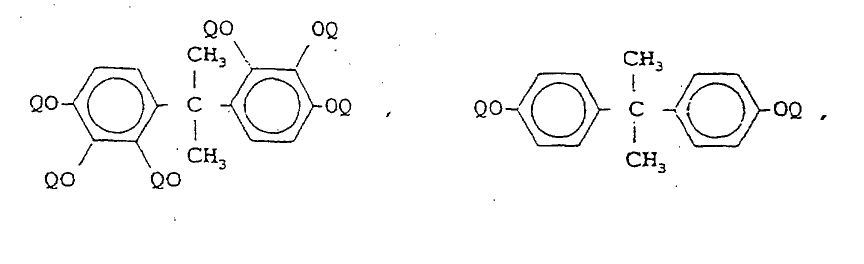 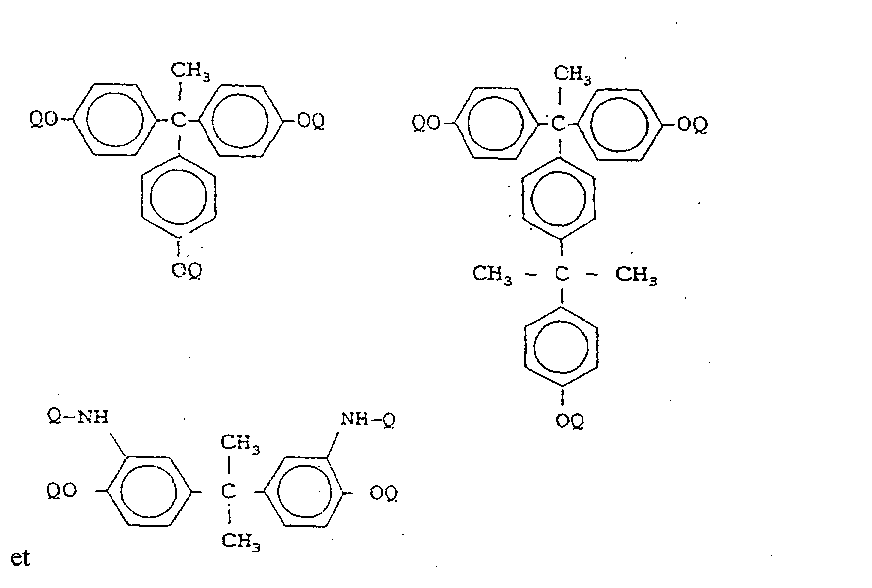 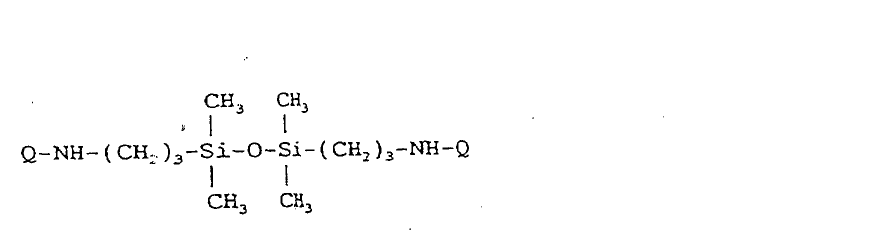 dans lesquelles Q est un atome d'hydrogène, 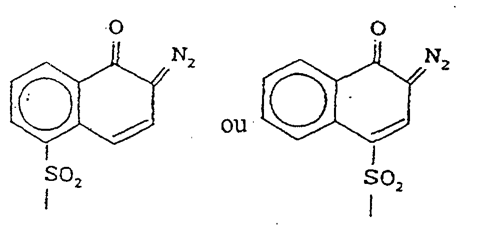 et au moins un radical Q dans chacun des composés ci-dessus est

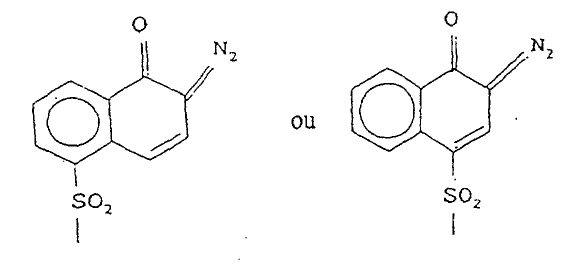

10. Procédé de traitement pour former un motif selon la revendication 1, dans lequel le polyamide est représenté par une quelconque des formules développées suivantes: 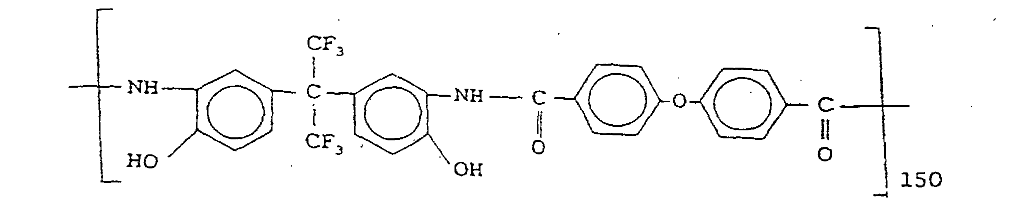 et

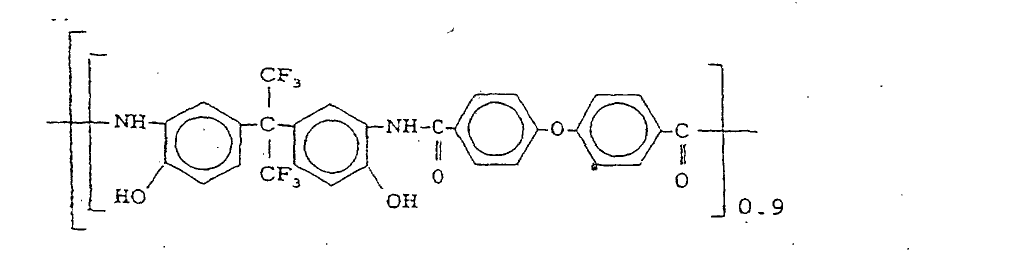

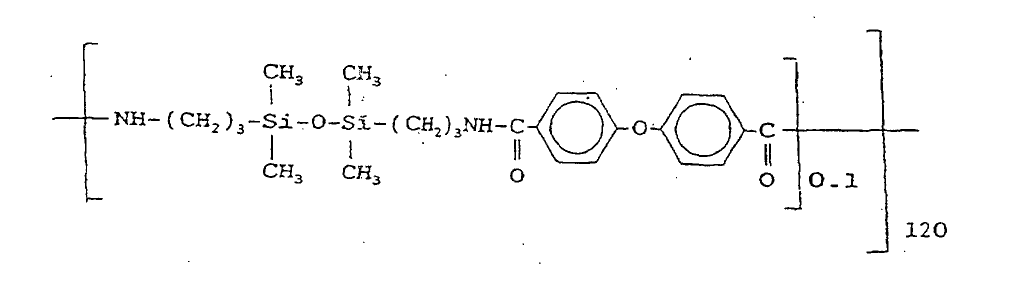

11. Procédé de traitement pour former un motif selon la revendication 1, dans lequel le composé diazoquinone répond à l'une quelconque des formules développées suivantes: 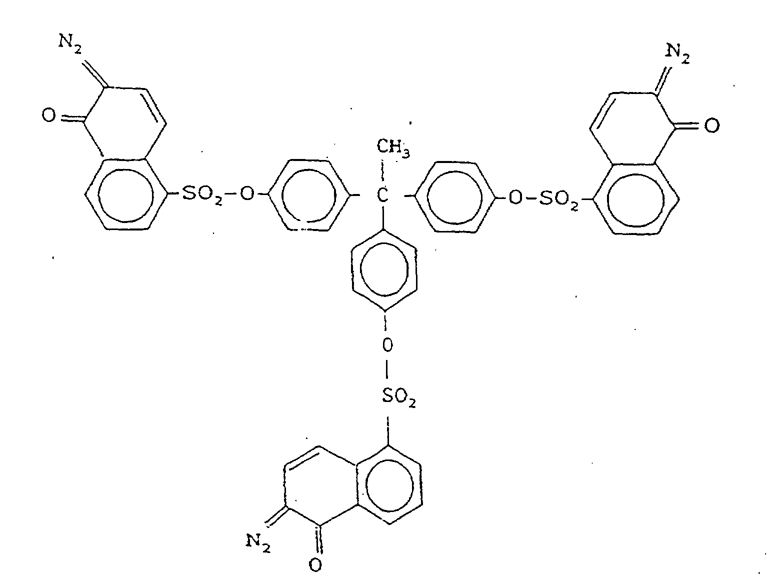 et
